# EUROPEAN PATENT APPLICATION

(11) **EP 4 485 525 A1**
(43) Date of publication of application: **01.01.2025**
(21) Application number: 24182612.2
(22) Date of filing: 17.06.2024
(51) Int. Cl.: H01L 23/31, H01L 21/56, H01L 23/495

(54) **QFN PACKAGED SEMICONDUCTOR DEVICE AND METHOD OF MAKING THEREOF**

(30) Priority: 29.06.2023 CN 202310785840
(71) Applicant: NXP USA, Inc., Austin TX 78735 (US)
(72) Inventor: Ge, You, 5656AG Eindhoven (NL); Wang, Zhijie, 5656AG Eindhoven (NL); Lee, Yit Meng, 5656AG Eindhoven (NL); Zaal, Jeroen Johannes Maria, 5656AG Eindhoven (NL)
(74) Representative: Hardingham, Christopher Mark

(57) **Abstract**

According to a first aspect of the present invention there is provided a QFN packaged semiconductor device (100) having a QFN bottom surface (45), the QFN packaged semiconductor device comprising: a die pad (10) on the QFN bottom surface; a die (30) on the die pad; a plurality of leads (20) spaced apart from the die pad and around a periphery of the QFN bottom surface; a plurality of bond wires (33) connecting the die and the leads; a molding compound (40) covering the die and the bond wires, which having an central region (47) and a peripheral region (42) , each central region having a first top surface (41) and first side faces (43), each peripheral region having a second top surface (46) and second side faces (44) , wherein the height of the peripheral region is lower than that of the central region.

## Description

### Field

This disclosure relates to integrated circuit (IC) packaging. More particularly, this disclosure relates to a quad-flat-no-leads (QFN) packaged semiconductor devices and a method of making thereof.

### Background

Board level reliability and solder joint reliability have always been challenges for QFN packaging, especially for small QFNs.

Limitations on the board level reliability and solder joint reliability of QFN packaging are mainly caused by the mismatch of CTE (coefficient of thermal expansion) between the EMC compound and the metal lead frame. In particular, solder breaks are easy to occur at bond wires around the QFN. This is mainly because a lot of stress is concentrated at the top of the bond wires around the QFN, and solder is more likely to detach or break at the bond wires around the QFN than in the middle area of the QFN.

Thus, reducing the thermal expansion mismatch effects between the package EMC compound and the metal lead frame may improve the board level reliability and solder joint reliability of QFN package.

### Summary

According to a first aspect of the present disclosure, there is provided a QFN packaged semiconductor device having a bottom surface, the QFN packaged semiconductor device comprising: a die pad on the bottom surface; a die on the die pad; a plurality of leads spaced apart from the die pad and around a peripheral region of the bottom surface; a plurality of bond wires connecting the die and the leads; a molding compound covering the die and the bond wires, wherein the QFN packaged semiconductor device has a first thickness in a central region and a second thickness across the peripheral region, and wherein the second thickness is less than the first thickness.

In one or more embodiments, the peripheral region surrounds the central region.

In one or more embodiments, a thickness of the molding compound in the central region is in a range between 0.7 and 3 times a thickness of the molding compound in the peripheral region.

In one or more embodiments, the central region extends beyond a perimeter of the die by a distance which is in a range between 0.7 and 1.3 times a thickness of the molding compound in the central region.

In one or more embodiments, the peripheral region extends inwards from the perimeter of the device by a distance which is in a range between 1 and 1.3 times an exposed length of the leads on the bottom surface.

In one or more embodiments, a thickness of the peripheral region is 0.2 and 0.4mm. In one or more embodiments, the central region has a first top surface, and a distance from the first top surface to a top surface of the die is in a range between 0.4 and 0.7 mm. In one or more embodiments, the central region has a first top surface and first side faces, the peripheral region has a second top surface and second side faces and the angle between the second top surface and the first side face is a right angle. In one or more embodiments, the angle between the second top surface and the first side face is an obtuse angle. In one or more embodiments, each first side face is a flat surface. In one or more other embodiments, each first side face is a curved surface.

According to another aspect of the present disclosure, there is provided a method of manufacturing a QFN packaged semiconductor device having a bottom surface, and comprising a die pad on the bottom surface, and a plurality of leads spaced apart from the die pad and around a peripheral region of the bottom surface, the method comprising: attaching a die on a die pad; forming wirebonds between the die and a plurality of leads; encapsulating the die and wirebonds with a molding compound, such that the QFN packaged semiconductor device has a first thickness in a central region and a second thickness across the peripheral region of the QFN packaged semiconductor device, wherein the second thickness is less than the first thickness; and singulating the QFN package.

In one or more embodiments, the peripheral region surrounds the central region.

In one or more embodiments, a thickness of the molding compound in the central region is in a range between 0.7 and 3 times a thickness of the molding compound in the peripheral region.

In one or more embodiments, the peripheral region extends inwards from the perimeter of the device by a distance which is between 1 and 1.3 times an exposed length of the leads on the bottom surface.

In one or more embodiments, the method further comprises: forming a second thickness in the peripheral region by sawing the molding compound of the peripheral region.

In one or more embodiments, a thickness of the peripheral region is in a range between 0.2 and 0.6mm.

In one or more embodiments, wherein each central region has a first top surface and first side faces, each peripheral region has a second top surface and second side faces, and the angle between the second top surface and the first side face is a right angle. In one or more other embodiments, the angle between the second top surface and the first side face is an obtuse angle. In one or more embodiments, the first side face is a flat surface. In one or more other embodiments, the first side face is a curved surface.

According to one or more embodiments, the thickness of the peripheral region of the molding compound around the QFN package is reduced. As a consequence, the stress above the leadswhich results from the mismatch of thermal expansion coefficient between, on the one part, the package molding compound and on hte other part the die and/or the metal lead frame, is reduced.

In one or more embodiments, the method further comprises: forming a second thickness in the peripheral region by sawing the molding compound of the peripheral region.

In one or more embodiments, the method further comprises: forming a second thickness in a peripheral region by adding a convex part in a mold of the molding compound.

In one or more embodiments, a thickness of the peripheral region is in a range between 0.2 and 0.6mm.

In one or more embodiments, the central region has a first top surface and first side faces, the peripheral region has a second top surface and second side faces, and the angle between the second top surface and the first side face is a right angle or an obtuse angle.

In one or more embodiments, central region has first side faces, and the first side face is a flat surface or a curved surface.

These and other aspects of the invention will be apparent from, and elucidated with reference to, the embodiments described hereinafter.

### Brief description of Drawings

Embodiments will be described, by way of example only, with reference to the drawings, in which
Figure 1 is a cross-sectional view of a QFN packaged semiconductor device according to one or more embodiments of the present disclosure;
Figure 2 is a cross-sectional view of a QFN packaged semiconductor device according to one or more embodiments of the present disclosure;
Figure 3 is a cross-sectional view of a QFN packaged semiconductor device according to one or more embodiments of the present disclosure;
Figure 4 is a flowchart for manufacturing a QFN packaged semiconductor device according to one or more embodiments of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### Detailed description of embodiments

Detailed illustrative embodiments of the present invention are disclosed herein. However, specific structural and functional details disclosed herein are merely representative for purposes of describing example embodiments of the present invention. The present invention may be embodied in many alternate forms and should not be construed as limited to only the embodiments set forth herein. Further, the terminology used herein is for the purpose of describing particular embodiments only and is not intended to be limiting of example embodiments of the invention.

As used herein, the singular forms "a," "an," and "the," are intended to include the plural forms as well, unless the context clearly indicates otherwise. It further will be understood that the terms "comprises," "comprising," "includes," and/or "including," specify the presence of stated features, steps, or components, but do not preclude the presence or addition of one or more other features, steps, or components. It also should be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

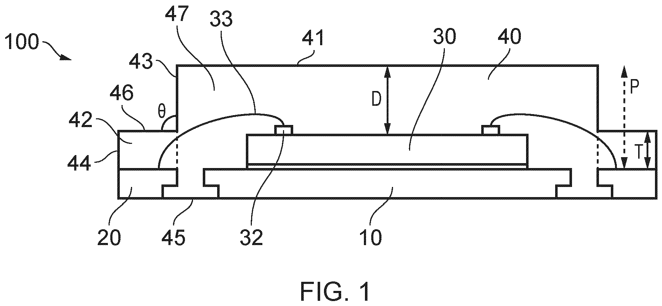

Referring now to FIG. 1, a cross-sectional view of QFN packaged semiconductor device according to one or more embodiments of the present disclosure is shown. The QFN packaged semiconductor device 100 comprises: a die pad 10, a plurality of leads 20, a die 30, which is typically rectangular or square and may also be referred to as a semiconductor die, and molding compound 40. The leads 20 typically comprise copper or a copper alloy. The die 30 is mounted on the die pad 10, which may also be referred to as a die paddle, typically by means of a conductive epoxy or other means known to the skilled person. The die pad 10 is typically rectangular and may be square and is generally larger than the die 30. The die pad 10 is generally centrally located, and a lower face of the die pad forms part of the bottom surface of the QFN packaged semiconductor device 100, that is to say it is away from the periphery of the QFN packaged semiconductor device 100. The leads 20 surround the die 30, typically on all four sides of the die 30 and die pad 10, and are spaced apart therefrom, with molding compound 40 therebetween. Typically, the leads 30 and the die pad 10 are formed from a same lead frame, and are initially integral but are then separated during the assembly process. Bond wires 33 are shown connecting bond pads 32 on the top surface of die 30 to the leads 20. The structure is encapsulated in the molding compound 40 except on an underside, or lower-most surface of the die pad 10 and leads 20. As shown in the figure, the lower-most surface and the outermost ends of the leads 20 are exposed and are not encapsulated or covered by molding compound 40.

The molding compound 40 has a central region 47 and a peripheral region 42. The central region 47 is a central region of the molding compound 40. The peripheral region 42 is a peripheral region of the molding compound 40. The central region 47 is generally centrally located above the die 30, that is to say it is away from the periphery of the QFN packaged semiconductor device 100. The peripheral region 42 is above the leads 20 around the periphery of the QFN packaged semiconductor device 100. The central region 47 has a thickness corresponding to the full thickness of the molding compound. This part may be described as having a full thickness and may be termed a full thickness part. The peripheral region 42 may be thinned during the assembly process, and thus may be described as a half-thickness area.

Each central region 47 has a first top surface 41 and first side faces 43, each peripheral region 42 has a second top surface 46 and second side faces 44, wherein each first side face 43 extends between the first top surface 41 and the second top 46 surface and is at an angle θ to the second top surface 46, and each second side face 44 extends vertically between the second top surface 46 and the bottom surface 45. The first side face 43 may be a flat surface. The angle θ may be a right angle. A thickness T of the peripheral region 42 may typically be within a range 0.1-0.4mm. The distance D from the top surface 41 of the molding compound 40 to the top surface of the die 30 may typically be within a range 0.4-0.7mm. The thickness T may be one fifth to four fifths of the distance D.

Comparing the QFN packaged semiconductor device 100, with a conventional QFN package in which the molding compound does not include a relatively thin peripheral region, it will be appreciated that the thickness T is less than the thickness of molding compound above the leads of a conventional QFN package, shown as "P" in FIG. 1. In particular, according to embodiments of the present invention the molding compound is not substantially thicker, around the peripheral region, and in particular above the leads, than it is in the central region. This may reduce or even completely avoid the problems associated with a difference in coefficient of thermal expansion (CTE) between the moulding compound and other parts of the packaged semiconductor device, in particular the semiconductor die 30 and the die pad 10 and leads 20. In conventional devices, the CTE difference, as already mentioned, can result in an increased stress and/or strain occurring around the peripheral region, leading to potential delamination or failure of solder joints. Considered from another perspective, the moulding compound according to embodiments of the present disclosure, more closely resembles a conformal coating or conformal covering of the die mounted on the lead frame (separated into electrically isolated die pad 10 and leads 20). Providing the moulding compound as a conformal coating or resembling or close to a conformal coating may, again, more equally distribute the stress and/or strain resulting from differences in CTE between the moulding compound 40 and either the die 30 or the die pad 10 and leads 20, thereby, again, reducing the likelihood of delamination or solder joint failure.

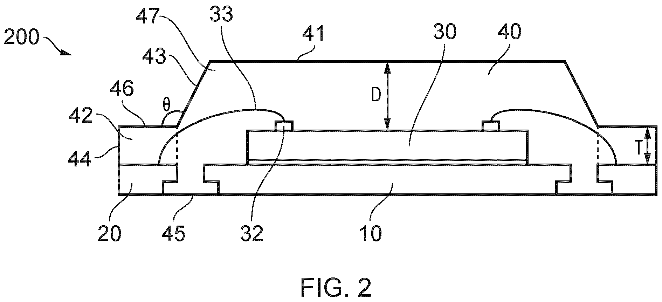

Now referring to Figure 2, similar to the device 100 shown in Figure 1, the QFN packaged semiconductor device 200 comprises: a die pad 10, a plurality of leads 20, a die 30. Each central region 47 has a first top surface 41 and first side faces 43, each peripheral region 42 has a second top surface 46 and second side faces 44, wherein each first side face 43 extends between the first top surface 41 and the second top 46 surface and is at an angle θ to the second top surface 46, and each second side face 44 extends vertically between the second top surface 46 and the QFN bottom surface 45. The first side faces 43 may be flat surfaces. The angle θ may be an obtuse angle. That is to say the top of central region 47 is smaller than the bottom. Providing sloping sidewalls may help to facilitate demoulding. In particular, removal, by vertical ejection of the packaged semiconductor device 200 from an injection molding tool which may be used to encapsulate the mounted semiconductor die with the molding compound is generally much easier in the case that there are no vertical surfaces of the molded device. This is because a vertical surface may "stick" against the vertical tool-wall during ejections. The thickness T of the peripheral region 42 may conveniently be 0.1-0.4mm. The distance D from the top surface 41 of the molding compound 40 to the top surface of the die 30 may conveniently be 0.4-0.7mm. The thickness T may typically be one fifth to four fifths of the distance D. In particular, it will be appreciated that since the leads 20 are thinner than, and less rigid than, the combination of the die pad 10 and the mounted die 30, an equal bending force or stress applied to the leads, due to CTE differences may provide more deflection or strain of the leads 20 than of the die 30 mounted on the die pad 10. It may thus be desirable that the thickness T of the moulding compound above the leads 20 is less than the distance D which corresponds to the thickness of the molding compound above the die 30, in order to reduce the stress at the leads 20 relative to the stress at the die 1030.

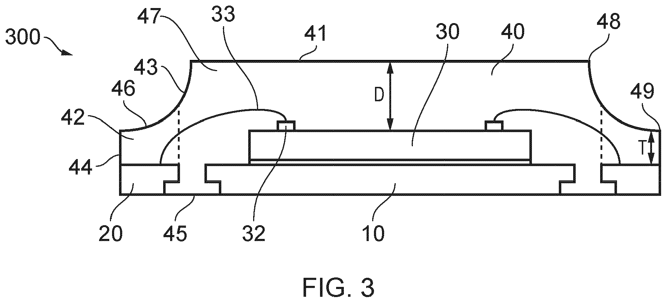

Now referring to Figure 3, similar to the devices shown in Figures 1 and 2, The QFN packaged semiconductor device 300 comprises: a die pad 10, a plurality of leads 20, a die 30. Each central region 47 has a first top surface 41 and first side faces 43, each peripheral region 42 has a second top surface 46 and second side faces 44, wherein each first side face 43 extending between the first top surface 41 and the second top 46 surface, and each second side face 44 extending vertically between the second top surface 46 and the QFN bottom surface 45. The first side faces 43 may be curved surfaces. The approximate thickness of the peripheral region 42 is T, which may conveniently be 0.1-0.4mm. The distance from the first top surface 41 of the molding compound 40 to the top surface of the die 30 is D, and D may conveniently be 0.4-0.7mm. The thickness T may typically be one fifth to four fifths of the distance D. Providing a curved profile to the thinner region of the moulding compound, and in particular a convex shape such as that shown in figure 3, may be convenient to facilitate moulding in a shaped mould tool, as discussed above. In case the profile is provided by the shape of a mould tool, corners 48 between the shaped sidewalls or first side faces 43 and the top surface, and the corner 49 between the shaped sidewalls and the second faces 43, may conveniently be rounded (not shown) in order to simplify the injection moulding process, as will be familiar to the skilled person. In other embodiments, as will be discussed in more detail below, the shaped profile may be provided by a partial cut through the package device by a saw blade; in this case, the corners need not be rounded, but may be sharp, as shown in figure 3.

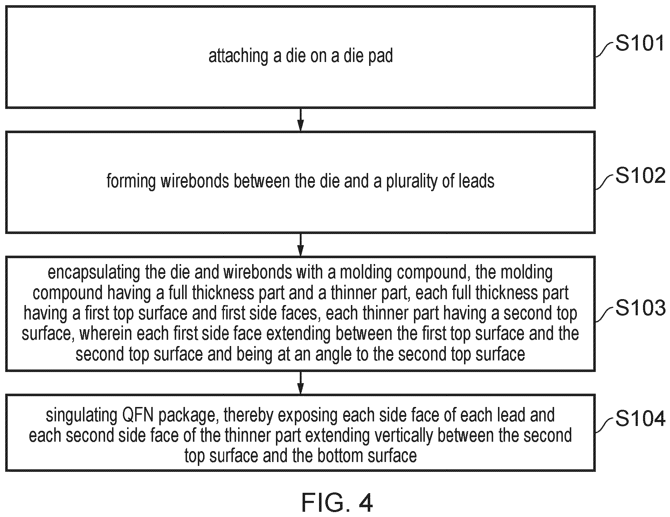

Referring now to FIG. 4, this shows a flow chart illustrating a method of manufacturing a QFN packaged semiconductor device according to one or more embodiments of the present invention. The QFN packaged semiconductor has a bottom surface and comprises a die pad on the bottom surface, and a plurality of leads spaced apart from the die pad and around a peripheral region of the bottom surface. The method comprises: S101, attaching a die on a die pad; S102 ("forming wirebonds between the die and a plurality of leads"), forming wirebonds between the die and a plurality of leads; S103, ("encapsulating the die and wirebonds with a molding compound, the molding compound having a full thickness part and a thinner part, each full thickness part having a first top surface and first side faces, each thinner part having a second top surface, wherein each first side face extending between the first top surface and the second top surface and being at an angle to the second top surface") encapsulating the die and wirebonds with a molding compound having a central region and a peripheral region, wherein the height of the peripheral region is lower than that of the central region; and S104 ("singulating QFN package, thereby exposing each side face of each lead and each second side face of the thinner part extending vertically between the second top surface and the bottom surface"), singulating the QFN package.

In one or more embodiments, each central region has a first top surface and first side faces, each peripheral region having a second top surface, wherein each first side face extending between the first top surface and the second top surface and being at an angle to the second top surface.

In one or more embodiments, optionally, there are at least two methods to form the peripheral region: the first method is to form the peripheral region of the molding compound that is above the leads initially at full thickness, and subsequently remove a top part or portion, for instance by making a partial cut with a saw or a cutting wheel; a second method is to use a shaped mold tool used during injection molding of the molding compound. This may be achieved, for example, by adding a convex part, to form a frame around the periphery of the upper half of the molding tool. Since the molding compound fills the space between the mold and the assembly of the die on the die-pad and the leads, adding a convex part to the mold, reduces the amount of molding compound which can be injection. The convex part corresponds to the inverse of the position and shape of the desired peripheral region and forms a peripheral region after demoulding. For example, as shown in Figure 1, the cross section of the convex part can be a rectangle, so the cross section of the peripheral region has a corresponding rectangular depression. As shown in Figure 2, the cross section of the convex part can be a trapezoid, so that the cross section of the peripheral region has a corresponding trapezoidal depression. As shown in Figure 3, the cross section of the convex part can be part of a circle or ellipse, or other - generally smooth - curve, so that the cross section of the peripheral region has a corresponding depression of the part of the circle or curve. Of course, the skilled person will appreciate that the mold tool itself may be made including the "convex part", instead of the convex part being a separate frame which is added to the mold.

In one or more embodiments, after singulating, each side face of each lead and each second side face of the peripheral region extending vertically between the second top surface and the bottom surface are exposed.

In one or more embodiments, the method of manufacturing a QFN packaged semiconductor device comprises: a thickness of the peripheral region is one fifth to four fifths of the distance from the first top surface to the top surface of the die.

In one or more embodiments, the method of manufacturing a QFN packaged semiconductor device comprises: a thickness of the peripheral region is 0.1-0.4mm.

In one or more embodiments, method of manufacturing a QFN packaged semiconductor device comprises: the distance from the first top surface to the top surface of the die is 0.4-0.7 mm.

In one or more embodiments, the angle to the peripheral region's face is a right angle. In one or more embodiments, the angle to the peripheral region's face is an obtuse angle. In one or more embodiments, the first side face of the semiconductor device is a flat surface. In one or more embodiments, the first side face of the semiconductor device is a curved surface.

Any range or device value given herein may be extended or altered without losing the effect sought, as will be apparent to the skilled person.

Although the invention has been described in the context of IC packages having a single die and a single electrical connector, it will be understood that the invention can be implemented in the context of IC packages having any suitable numbers of dies and any suitable numbers of electrical connectors.

Also, for purposes of this description, the terms "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

The use of figure numbers and/or figure reference labels in the claims is intended to identify one or more possible embodiments of the claimed subject matter in order to facilitate the interpretation of the claims. Such use is not to be construed as necessarily limiting the scope of those claims to the embodiments shown in the corresponding figures.

Unless explicitly stated otherwise, each numerical value and range should be interpreted as being approximate as if the word "about" or "approximately" preceded the value or range.

It will be understood that various changes in the details, materials, and arrangements of the parts which have been described and illustrated in order to explain embodiments of this invention may be made by those skilled in the art without departing from embodiments of the invention encompassed by the following claims.

It should be understood that the steps of the exemplary methods set forth herein are not necessarily required to be performed in the order described, and the order of the steps of such methods should be understood to be merely exemplary. Likewise, additional steps may be included in such methods, and certain steps may be omitted or combined, in methods consistent with various embodiments of the invention.

Although the elements in the following method claims, if any, are recited in a particular sequence with corresponding labeling, unless the claim recitations otherwise imply a particular sequence for implementing some or all of those elements, those elements are not necessarily intended to be limited to being implemented in that particular sequence.

Reference herein to "one embodiment" or "an embodiment" means that a particular feature, structure, or characteristic described in connection with the embodiment can be included in at least one embodiment of the invention. The appearances of the phrase "in one embodiment" in various places in the specification are not necessarily all referring to the same embodiment, nor are separate or alternative embodiments necessarily mutually exclusive of other embodiments. The same applies to the term "implementation."

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

## Claims

1. A quad-flat-no-lead, QFN, packaged semiconductor device having a bottom surface, the QFN packaged semiconductor device comprising:
a die pad on the bottom surface;
a die on the die pad;
a plurality of leads spaced apart from the die pad and around a peripheral region of the bottom surface;
a plurality of bond wires connecting the die and the leads, and
a molding compound covering the die and the bond wires;
wherein the QFN packaged semiconductor device has a first thickness in a central region and a second thickness across the peripheral region, and
wherein the second thickness is less than the first thickness.

2. A QFN packaged semiconductor device according to claim 1, wherein the peripheral region surrounds the central region.

3. A QFN packaged semiconductor device according to claim 1 or 2, wherein a thickness of the molding compound in the central region is in a range between between 0.7 and 3 times a thickness of the molding compound in the peripheral region.

4. A QFN packaged semiconductor device according to any preceding claim, wherein the central region extends beyond a perimeter of the die by a distance which is in a range between 0.7 and 1.3 times a thickness of the molding compound in the central region.

5. A QFN packaged semiconductor device according to any preceding claim, wherein the peripheral region extends inwards from the perimeter of the device by a distance which is in a range between 1 and 1.3 times an exposed length of the leads on the bottom surface.

6. A QFN packaged semiconductor device according to any preceding claim 1, wherein a thickness of the peripheral region is in a range between 0.2 and 0.6mm.

7. A QFN packaged semiconductor device according to any preceding claim, wherein the central region has a first top surface, and a distance from the first top surface to a top surface of the die is in a range between 0.4 and 0.7 mm.

8. A QFN packaged semiconductor device according to any preceding claim, wherein the central region has a first top surface and first side faces, the peripheral region has a second top surface and second side faces, and the angle between the second top surface and the first side face is a right angle.

9. A QFN packaged semiconductor device according to any of claims 1 to 7, wherein the central region has a first top surface and first side faces, the peripheral region has a second top surface and second side faces, and the angle between the second top surface and the first side face is an obtuse angle.

10. A QFN packaged semiconductor device according to any preceding claim, wherein the central region has first side faces, and each first side face is a flat surface.

11. A QFN packaged semiconductor device according to any ofclaims1 to 9, wherein the central region has first side faces, and the first side face is a curved surface.

12. A method of manufacturing a quad-flat-no-leads, QFN, packaged semiconductor device having a bottom surface, and comprising a die pad on the QFN bottom surface, and a plurality of leads spaced apart from the die pad and around a peripheral region of the bottom surface, the method comprising:
attaching a die on the die pad;
forming wirebonds between the die and a plurality of leads;
encapsulating the die and wirebonds with a molding compound, such that the QFN packaged semiconductor device has a first thickness in a central region of the QFN packaged semiconductor device and a second thickness across the peripheral region of the QFN packaged semiconductor device, wherein the second thickness is less than the first thickness; and
singulating the QFN packaged semiconductor device.

13. A method of manufacturing a QFN packaged semiconductor device according to claim 12, wherein the peripheral region surrounds the central region.

14. A method of manufacturing a QFN packaged semiconductor device according to claim 12 or 13, wherein a thickness of the molding compound in the central region is in a range between 0.7 and 3 times a thickness of the molding compound in the peripheral region.

15. A method of manufacturing a QFN packaged semiconductor device according to any of claims 12 to 14, wherein the peripheral region extends inwards from the perimeter of the device by a distance which is between 1 and 1.3 times an exposed length of the leads on the bottom surface.
